# EUROPEAN PATENT APPLICATION

(11) **EP 1 122 945 A1**
(43) Date of publication of application: **08.08.2001**
(21) Application number: 00951965.3
(22) Date of filing: 11.08.2000
(51) Int. Cl.: H04N 5/225, H04N 5/335

(54) **IMAGE PICKUP DEVICE AND CAMERA**

(30) Priority: 19.08.1999 JP 23274199
(71) Applicant: MITSUBISHI DENKI KABUSHIKI KAISHA, Tokyo 100-8310 (JP)
(72) Inventor: TOYODA, Takashi, Mitsubishi Denki K. K., Tokyo 100-8310 (JP); MURAO, Fumihide, Mitsubishi Denki K. K., Tokyo 100-8310 (JP); KOMORI, Shinji, Mitsubishi Denki K. K., Tokyo 100-8310 (JP)
(74) Representative: Popp, Eugen, Dr.
(86) International application number: JP0005419
(87) International publication number: WO0115433

(57) **Abstract**

The image pickup apparatus comprises a holder (8) for holding optical parts; and a holder holding member (9), a part of which is engaged with the holder (8), for holding a package (7) enclosing an image pickup device (4) in an engaged state. A first engagement portion (11) provided for the holder (8) and a second engagement portion (12) provided for the holder holding member (9) are engaged with each other to sandwich the package (7) from the upper and lower sides, and at least one of the holder (8) and the holder holding member (9) has a structure by which the holder (8) and the holder holding member (9) are pressed against each other, thereby integrating the package (7) and the optical parts. By the arrangement, a condition which limits the shape of the package is eliminated, and the image pickup apparatus having excellent strength in integration between the optical system and the package, excellent light shielding performance, the reduced number of parts, and the reduced number of assembling steps is obtained.

## Description

### TECHNICAL FIELD

The present invention relates to an image pickup apparatus having a structure capable of holding a package enclosing an image pickup device and optical parts by a holder and a holder holding member and a camera having the image pickup apparatus.

### BACKGROUND ART

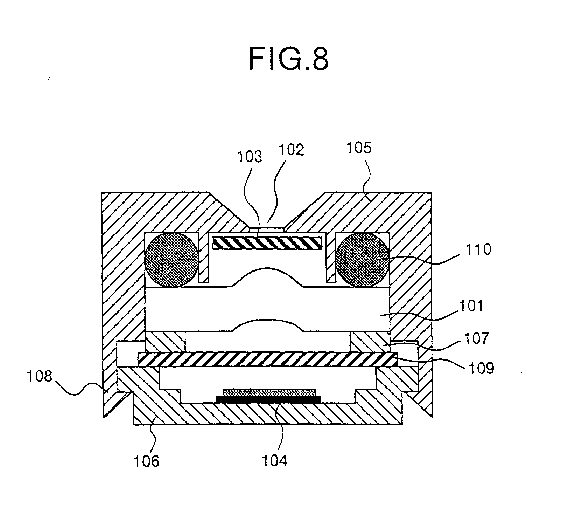

A conventional image pickup apparatus will be described hereinbelow. For example, there are image pickup devices of a CCD type, a MOS type, an amplification type, and the like each for use in a conventional image pickup apparatus. Fig. 8 is a diagram showing the configuration of an image pickup apparatus disclosed in Japanese Patent Application Laid-Open (JP-A) No. 10-321827 as an example of a conventional image pickup apparatus using such an image pickup device.

Shown in Fig. 8 are an image forming lens 101 for forming an image on an image pickup device, an aperture 102, an infrared ray cut filter 103, an image pickup device 104, a holder 105 for holding the image forming lens 101 and the infrared ray cut filter 103, a package 106 for enclosing the image pickup device 104, a spacer 107 for adjusting a focal length of the image forming lens 101, an engagement nail 108 for retaining the holder 105 by the package 106, a cover glass 109, and an elastic member 110 for absorbing play of the holder 105.

As described above, in the conventional image pickup apparatus, by engaging the engagement nail 108 with a part of the package 106, the optical system (image forming lens 101, aperture 102, and infrared ray cut filter 103) and the package 106 enclosing the image pickup device 104 are integrated with each other, thereby realizing miniaturization of the image pickup apparatus.

In the conventional image pickup apparatus, when there is a dimensional error in the holder 105 and the image forming lens 101, by optimizing the thickness of the spacer 107, the focal length of the image forming lens 101 is adjusted. At this time, a force pressing the image forming lens 101 against the package 106 side and a force pressing the holder 105 against the opposite side of the package 106 simultaneously act by the elastic member 110 to thereby absorb the dimensional error, so that the optical system and the package 106 are integrated with each other.

In the conventional image pickup apparatus, however, the integration with the package 106 is achieved only by using the engagement nail 108 of the holder 105. Consequently, the package 106 itself has to be provided with an engaging structure. It causes a problem such that the shape of the package 106 has to be limited. Since the package 106 is held only by the engagement nail 108, when there is a gap in a contact face (side face) between the holder 105 and the package 106 due to a dimensional error, a problem such that a sufficient strength in integration cannot be obtained arises.

In the conventional image pickup apparatus, the engagement nail 108 has to be widened at the time of integration with the package 106, so that-a slit for guiding integration always exists in a contact portion between the holder 105 and the package 106. A problem such that it is difficult to achieve complete light shield due to the above occurs.

In the conventional image pickup apparatus, there is also the possibility that a manufacture dimensional error occurs in the holder 105, image forming lens 101, package 106, or the like. In order to perfectly integrate the holder 105 and the package 106 with each other, the elastic member 110 is always necessary, so that there is a problem such that the number of parts and the number of assembling steps increase.

It is therefore an object of the invention to eliminate the condition which limits the shape of the package and to provide an image pickup apparatus having excellent strength in integration between an optical system and a package, good light shielding performance, less parts, and less assembling steps. It is also an object of this invention to provide a camera that uses such an image pickup apparatus.

### DISCLOSURE OF THE INVENTION

The image pickup apparatus according to one aspect of this invention comprises a holder for holding optical parts; and a holder holding member, a part of which is engaged with the holder, for holding a package enclosing an image pickup device in an engaged state. Further, a first engagement portion provided for the holder and a second engagement portion provided for the holder holding member are engaged with each other to sandwich the package from the upper and lower sides. At least one of the holder and the holder holding member has a structure by which the holder and the holder holding member are pressed against each other, thereby integrating the package and the optical parts. According to this aspect of the present invention, the package is sandwiched by the holder and the holder holding member, so that it is unnecessary to provide the package with a special structure for attaching the holder. At least one of the holder and the holder holding member has the structure by which they are pressed against each other. It is also unnecessary to provide an elastic member used in the conventional technique to absorb a dimensional error in manufacture.

Furthermore, an elastic curved portion (corresponding to a curved portion 14) is provided for the holder holding member (corresponding to a holder holding member 9 which will be described hereinlater). The second engagement portion (corresponding to a second engagement portion 12) in the holder holding member has the structure of an engagement hole and, when the first engagement portion (corresponding to a first engagement portion 11) and the second engagement portion are engaged with each other and the curved portion is pressed down, the holder (corresponding to a holder 8) and the holder holding member are pressed against each other. Since the elastic curved portion is provided in the contact portion between the holder holding member and the package, the holder and the holder holding member are pressed against each other to thereby firmly sandwich the package.

Furthermore, an inclined face (corresponding to an inclined face 15) is provided for the first engagement portion (corresponding to a first engagement portion 11a) in the holder (corresponding to a holder 8a). The second engagement portion (corresponding to a second engagement portion 12a) in the holder holding member (corresponding to a holder holding member 9a) has the structure of an engagement hole, the inclined face of the first engagement portion and the second engagement portion are engaged with each other, and the holder and the holder holding member are pressed against each other by a repulsive force applied along the inclined face to the holder holding member. Since the inclined face is provided for the first engagement portion in the holder, when the holder and the holder holding member are engaged with each other, a force acts so that the second engagement portion is opened outward along the inclined face. By the force repelling it, the holder and the holder holding member are pressed against each other to thereby firmly sandwich the package.

Furthermore, an elastic curved portion is provided for the holder holding member (corresponding to a holder holding member 9b), the second engagement portion (corresponding to a second engagement portion 12b) in the holder holding member has the structure of an engagement nail and, when the first and second engagement portions are engaged with each other and the curved portion is pressed down, the holder and the holder holding member are pressed against each other. The elastic curved portion is provided for the contact portion with the package of the holder holding member and the second engagement portion of the engagement nail structure is provided. Consequently, when the first and second engagement portions are engaged with each other, the holder and the holder holding member are pressed against each other to thereby firmly sandwich the package. The holder holding member having the second engagement portion of the structure of the engagement nail can be molded by using a resin such as plastic, so that the manufacture is facilitated.

Furthermore, an inclined face (corresponding to an inclined face 16) is provided for the second engagement portion (corresponding to a second engagement portion 12c) in the holder holding member (corresponding to a holder holding member 9c). The second engagement portion in the holder holding member has the structure of an engagement nail and, when the first engagement portion and the inclined face of the second engagement portion are engaged with each other, the holder and the holder holding member are pressed against each other by a repulsive force applied along the inclined face to the holder holding member. Since the second engagement portion in the holder holding member has the inclined face, when the holder and the holder holding member are engaged with each other, a force acts so that the second engagement portion is opened outward along the inclined face and, by the force repelling it, the holder and the holder holding member are pressed against each other to thereby firmly sandwich the package.

Furthermore, an inclined face is provided for the first engagement portion in the holder. The second engagement portion (corresponding to a second engagement portion 12d) in the holder holding member (corresponding to a holder holding member 9d) has the structure of an engagement nail and, when the inclined face of the first engagement portion and the second engagement portion are engaged with each other, the holder and the holder holding member are pressed against each other by a repulsive force applied along the inclined face to the holder holding member. Since the first engagement portion in the holder has the inclined face, when the holder and the holder holding member are engaged with each other, a force acts so that the second engagement portion is opened outward along the inclined face and, by the force repelling it, the holder and the holder holding member are pressed against each other to thereby firmly sandwich the package.

Furthermore, there is provided a projection (corresponding to a projection 17) for defining a holding position between the rear face of the package and the holder holding member. Thus, by fixing the package and the holder holding member, the package is stably held.

Furthermore, a distance between an image forming lens (corresponding to an image forming lens 20 with legs) as one of the optical parts and the image pickup device (corresponding to the image pickup device 4) is fixed, thereby making adjustment of a focal length unnecessary. Thus, by fixing the distance between the image forming lens and the image pickup device, the adjustment of the focal length becomes unnecessary.

The camera according to another aspect of this invention comprises an image pickup apparatus. In this image pickup apparatus, a first engagement portion provided for a holder for holding optical parts and a second engagement portion provided for a holder holding member are engaged with each other to sandwich a package enclosing an image pickup device from the upper and lower sides. Further, at least one of the holder and the holder holding member has a structure by which the holder and the holder holding member are pressed against each other, thereby integrating the package and the optical parts. Thus, it is not necessary in the image pickup apparatus in which it is unnecessary to provide the package with a special structure for attaching the holder, at least one of the holder and the holder holding member has the structure by which they are pressed against each other, and it is unnecessary to provide an elastic member for absorbing a dimensional error in manufacture is used.

### BRIEF DESCRIPTION OF THE DRAWINGS

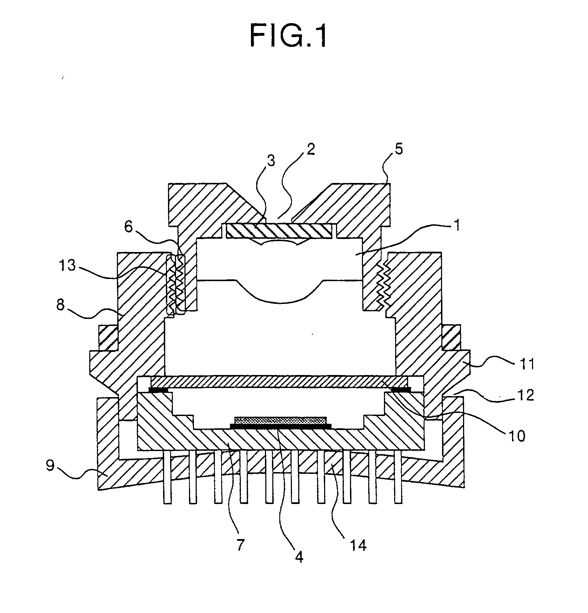

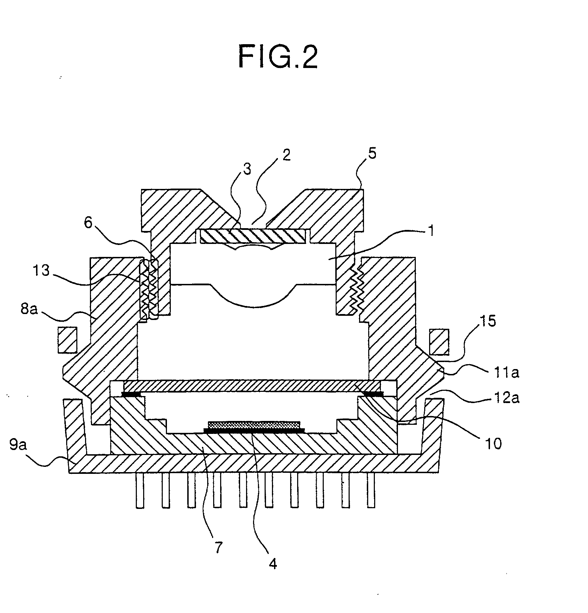

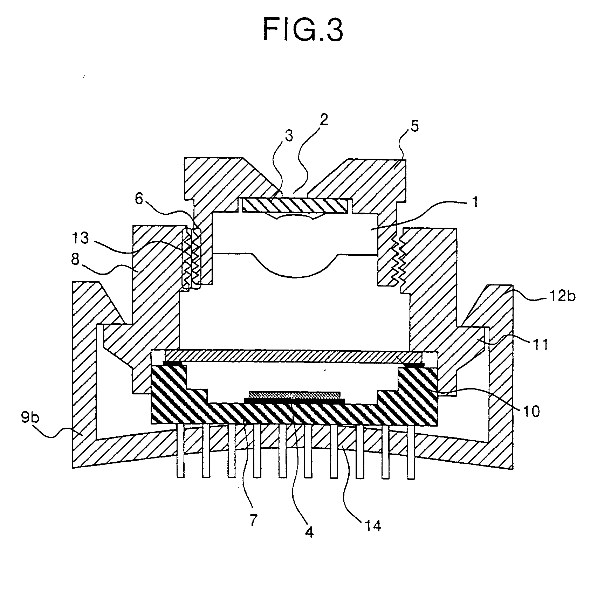

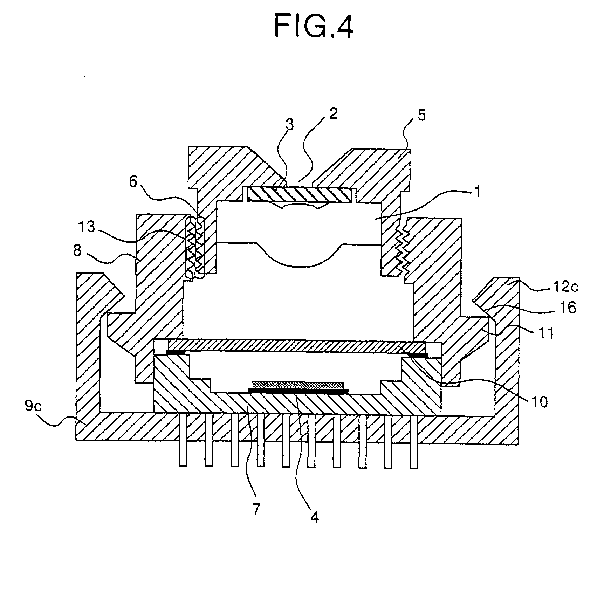

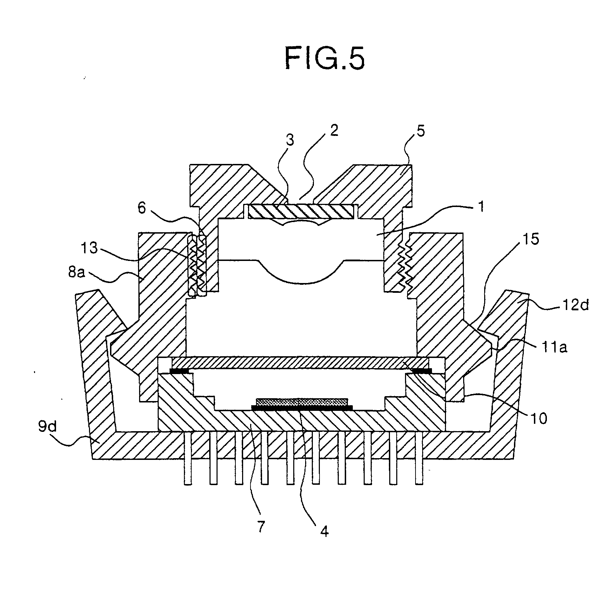

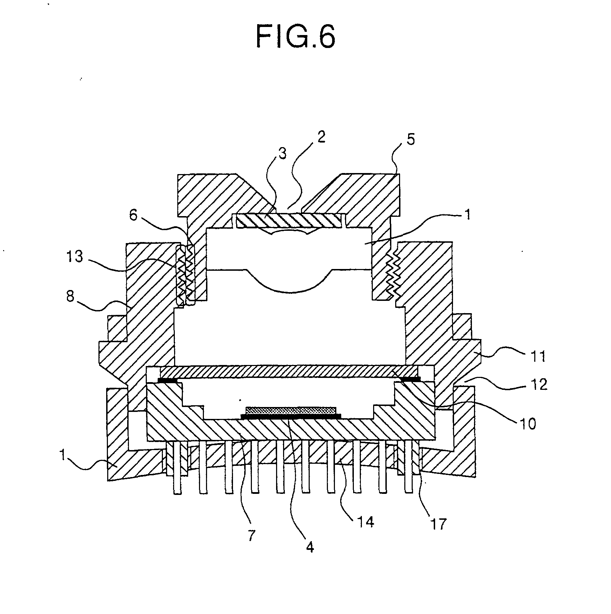

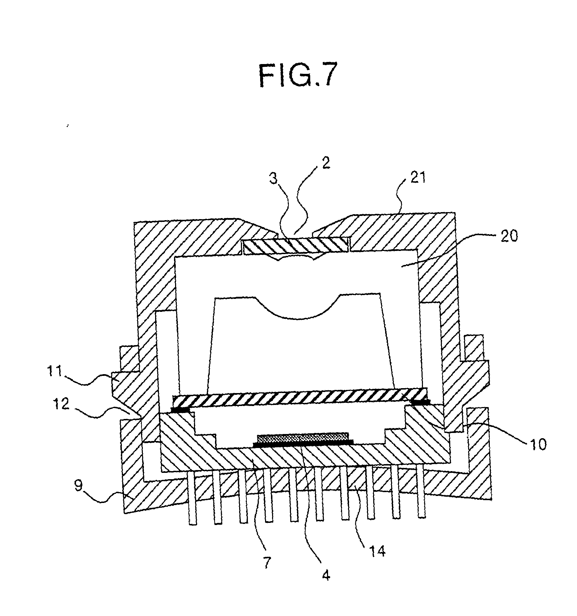

Fig. 1 is a diagram showing the configuration of a first embodiment of an image pickup apparatus according to the invention, Fig. 2 is a diagram showing the configuration of a second embodiment of the image pickup apparatus according to the invention, Fig. 3 is a diagram showing the configuration of a third embodiment of the image pickup apparatus according to the invention, Fig. 4 is a diagram showing the configuration of a fourth embodiment of the image pickup apparatus according to the invention, Fig. 5 is a diagram showing the configuration of a fifth embodiment of the image pickup apparatus according to the invention, Fig. 6 is a diagram showing the configuration of a sixth embodiment of the image pickup apparatus according to the invention, Fig. 7 is a diagram showing the configuration of a seventh embodiment of the image pickup apparatus according to the invention, and Fig. 8 is a diagram showing the configuration of a conventional image pickup apparatus disclosed in Japanese Patent Application Laid-Open (JP-A) No. 10-321827.

### BEST MODE FOR CARRYING OUT THE INVENTION

Preferred embodiments of the image pickup apparatus and the camera according to this invention will be described in detail hereinbelow with reference to the drawings. The invention is not limited to the embodiments.

Fig. 1 is a diagram showing the configuration of a first embodiment of an image pickup apparatus according to the invention. Shown in Fig. 1 are an image forming lens 1 for forming an image of the subject onto the face of an image pickup device, an aperture 2, an infrared ray cut filter 3, an image pickup device 4, a lens barrel 5 for holding the image forming lens 1 and the infrared ray cut filter 3 and simultaneously having the aperture 2, a male screw portion 6 formed on a side face of the lens barrel 5, a package 7 for enclosing the image pickup device 4, a holder 8 for holding the lens barrel 5, a holder holding member 9 for holding the holder 8, a cover glass 10 placed on the top face of the package 7, a first engagement portion 11 provided in a part of the holder 8, a second engagement portion 12 provided in a part of the holder holding member 9, a female screw portion 13 provided in the holder 8, and a curved portion 14 in which the holder holding member 9 and the rear face of the package 7 are in contact with each other. The image pickup apparatus in the embodiment is applied to each of various cameras such as a video camera.

In the image pickup apparatus constructed as described above, the holder 8 and the holder holding member 9 which are engaged with each other in a part of the contact face hold the package 7 enclosing the image pickup device 4 by sandwiching the package 7 from the upper and lower sides. Further, the image pickup apparatus has a structure such that the female screw portion 13 in the holder 8 and the male screw portion 6 in the lens barrel 5 for holding the optical parts (corresponding to the image forming lens 1, aperture 2, and infrared ray cut filter 3) are screwed to each other, thereby fixing the holder 8 and the lens barrel 5.

As described above, the holder 8 and the holder holding member 9 sandwich the package 7 from the upper and lower sides. Simultaneously, in the image pickup apparatus, at least one of the holder 8 and the holder holding member 9 has the structure of pressing the other, so that the holder 8 and the holder holding member 9 are firmly integrated with each other. In the embodiment, the holder holding member 9 is provided with the elastic curved portion 14, and the first and second engagement portions 11 and 12 are engaged with each other, thereby pressing the curved portion 14 down. A force acts in the direction that the holder 8 and the holder holding member 9 are pressed against each other, and the package 7 is firmly sandwiched.

According to the first embodiment, the package 7 is sandwiched by the holder 8 and the holder holding member 9 from the upper and lower sides. It is therefore unnecessary to provide the package 7 with a special structure for attaching the holder 8, for example, a structure for engagement with the holder (refer to the package 106 in Fig. 8). That is, according to the first embodiment, unlike the conventional technique, it is not necessary to limit the package shape.

According to the first embodiment, the structure of sandwiching the package 7 by the holder 8 and the holder holding member 9 is employed. Consequently, as compared with the conventional structure of directly engaging the holder 8 with the package 7, the light shielding performance can be improved.

According to the first embodiment, the contact portion with the package 7, of the holder holding member 9 has the elastic curved portion 14, so that the holder 8 and the holder holding member 9 are pressed against each other and can firmly sandwich the package 7. That is, in the embodiment, the strength in integration can be largely improved.

According to the first embodiment, by the firm integration as described above, it becomes unnecessary to provide the elastic member used in the conventional technique to absorb a dimensional error in manufacture. Thus, the number of parts and the number of assembling steps can be decreased. All of the embodiments which will be described hereinlater can obtain an effect similar to the above (effect at reducing the number of parts and the number of assembling steps). Although the image forming lens 1, infrared ray cut filter 3, and aperture 2 are used as optical parts in the above description, the invention is not limited to the parts. A similar effect can be obtained by other optical parts.

Fig. 2 is a diagram showing the configuration of a second embodiment of the image pickup apparatus. In the second embodiment, the same reference numerals are given to components similar to those in the foregoing first embodiment and their description will not be repeated.

Shown in Fig. 2 are a holder 8a for holding the lens barrel 5, having a shape different from that of the holder 8, a holder holding member 9a for holding the holder 8a, a first engagement portion 11a provided in a part of the holder 8a, a second engagement portion 12a provided in a part of the holder holding member 9a, and an inclined face 15 provided in the first engagement portion 11a. The image pickup apparatus in the embodiment is applied to various cameras such as a video camera in a manner similar to the first embodiment.

In the image pickup apparatus constructed as described above, the holder 8a and the holder holding member 9b which are engaged with each other in a part of the contact face sandwich the package 7 for enclosing the image pickup device 4 from the upper and lower sides. Further, the image pickup apparatus has the structure such that the female screw portion 13 in the holder 8a and the male screw portion 6 in the lens barrel 5 for holding the optical parts (corresponding to the image forming lens 1, aperture 2, and the infrared ray cut filter 3) are screwed to each other, thereby fixing the holder 8a and the lens barrel 5.

As described above, the holder 8a and the holder holding member 9a sandwich the package 7 from the upper and lower sides and, simultaneously, in the image pickup apparatus, at least one of the holder 8a and the holder holding member 9a is provided with the structure by which they are pressed against each other, thereby firmly integrating the holder 8a and the holder holding member 9a. Specifically, in the embodiment, the second engagement portion 12a provided in a part of the holder holding member 9a is retained by the inclined face 15 of the first engagement portion 11a provided in the holder 8a to thereby realize the integration.

By manufacturing the holder 8a and the holder holding member 9a so that their dimensions in the Z axis (vertical) direction have minus tolerances in an engaged state, the package 7 is sandwiched by the holder 8a and the holder holding member 9a. Consequently, a force acts so that the second engagement portion 12a is opened outward along the inclined face 15, and by a force against it, the integration of the holder 8a and the holder holding member 9a becomes firm.

Since the second embodiment employs the structure of sandwiching the package 7 from the upper and lower sides by the holder 8a and the holder holding member 9a, an effect similar to that of the foregoing first embodiment is obtained. Further, since the first engagement portion 11a in the holder 8a has the inclined face 15, when the holder 8a and the holder holding member 9a are engaged with each other, the force acts so that the second engagement portion 12a is opened outward along the inclined face 15. By a force repelling it, the holder 8a and the holder holding member 9a are pressed against each other, so that the package 7 can be firmly sandwiched. That is, in the embodiment, the strength in integration can be largely improved.

Fig. 3 is a diagram showing the configuration of a third embodiment of the image pickup apparatus . In the third embodiment, the same reference numerals are given to components similar to those of the foregoing first embodiment and their description will not be repeated.

Shown in Fig. 3 are a holder holding member 9b for holding the holder 8, a second engagement portion 12b provided in a part of the holder holding member 9b, and the curved portion 14 in which the holder holding member 9a and the rear face of the package 7 are in contact with each other. The image pickup apparatus in the embodiment is applied to various cameras such as a video camera in a manner similar to the first embodiment.

In the image pickup apparatus constructed as described above, the holder 8 and the holder holding member 9b which are engaged in with each other in a part of the contact part sandwich the package 7 for enclosing the image pickup device 4 from the upper and lower sides, thereby holding the package 7. Further, the image pickup apparatus has a structure such that the female screw portion 13 in the holder 8 and the male screw portion 6 in the lens barrel 5 for holding the optical parts (corresponding to the image forming lens 1, aperture 2, and infrared ray cut filter 3) are screwed to each other to thereby fix the holder 8 and the lens barrel 5.

The holder 8 and the holder holding member 9b sandwich the package 7 from the upper and lower sides and, simultaneously, in the image pickup apparatus, at least one of the holder 8 and the holder holding member 9b is provided with the structure by which they are pressed against each other, thereby firmly integrating the holder 8 and the holder holding member 9b with each other.

In the third embodiment, the holder holding member 9b is provided with the elastic curved portion 14. The second engagement portion 12b in the holder holding member 9b has an engagement nail structure. By the structure, when the first and second engagement portions 11 and 12b are engaged with each other, the curved portion 14 is pressed down, and a force acts in the direction of pressing the holder 8 and the holder holding member 9b against each other to thereby firmly sandwich the package 7.

Since the embodiment employs the structure of sandwiching the package 7 from the upper and lower sides by the holder 8 and the holder holding member 9b, an effect similar to that of the foregoing first embodiment is obtained. Further, the elastic curved portion 14 is provided in the contact portion with the package 7 of the holder holding member 9b and, in addition, the second engagement portion 12b having the engagement nail structure is provided. Consequently, when the first and second engagement portions 11 and 12b are engaged with each other, the holder 8 and the holder holding member 9b are pressed against each other and can firmly sandwich the package 7. That is, the embodiment can largely improve the strength in integration. The holder holding member 9b having the second engagement portion 12b of the engagement nail structure can be molded by using a resin such as plastic, so that manufacture is facilitated.

Fig. 4 is a diagram showing the configuration of a fourth embodiment of the image pickup apparatus. In the fourth embodiment, the same reference numerals are given to components similar to those of the foregoing first embodiment and their description will not be repeated.

Shown in Fig. 4 are a holder holding member 9c for holding the holder 8, a second engagement portion 12c provided in a part of the holder holding member 9c, and an inclined face 16 provided in the second engagement portion 12c. The image pickup apparatus in the embodiment is applied to various cameras such as a video camera in a manner similar to the first embodiment.

In the image pickup apparatus constructed as described above, the holder 8 and the holder holding member 9c which are engaged in with each other in a part of the contact face hold the package 7 for enclosing the image pickup device 4 by sandwiching the package 7 from the upper and lower sides . Further, the image pickup apparatus has a structure such that the female screw portion 13 in the holder 8 and the male screw portion 6 in the lens barrel 5 for holding the optical parts (corresponding to the image forming lens 1, aperture 2, and infrared ray cut filter 3) are screwed to each other to thereby fix the holder 8 and the lens barrel 5.

The holder 8 and the holder holding member 9c sandwich the package 7 from the upper and lower sides and, simultaneously, in the image pickup apparatus, at least one of the holder 8 and the holder holding member 9c is provided with the structure by which they are pressed against each other, thereby firmly integrating the holder 8 and the holder holding member 9c. Specifically, in the fourth embodiment, the inclined face 16 provided for the second engagement portion 12c is retained by the first engagement portion 11 provided for the holder 8 to thereby realize the integration.

The second engagement portion 12c in the holder holding member 9c has the engagement nail structure and the holder 8 and the holder holding member 9c are manufactured so that their dimensions in the Z axis (vertical) direction have minus tolerances in an engaged state, thereby sandwiching the package 7 by the holder 8 and the holder holding member 9c. Consequently, a force acts so that the second engagement portion 12c is opened outward along the inclined face 16, and by a force repelling it, the integration of the holder 8 and the holder holding member 9c becomes firm.

Since the fourth embodiment employs the structure of sandwiching the package 7 from the upper and lower sides by the holder 8 and the holder holding member 9c, an effect similar to that of the foregoing first embodiment is obtained. Further, since the inclined face 16 is provided for the second engagement portion 12c in the holder holding member 9c, when the holder 8 and the holder holding member 9c are engaged with each other, the force acts so that the second engagement portion 12c is opened outward along the inclined face 16. By a force repelling it, the holder 8 and the holder holding member 9c are pressed against each other, so that the package 7 can be firmly sandwiched. That is, in the fourth embodiment, the strength in integration can be largely improved.

Fig. 5 is a diagram showing the configuration of a fifth embodiment of the image pickup apparatus. In the fifth embodiment, the same reference numerals are given to components similar to those of the foregoing first and second embodiments and their description will not be repeated.

Shown in Fig. 5 are a holder holding member 9d for holding the holder 8a and a second engagement portion 12d provided in a part of the holder holding member 9d. The image pickup apparatus in the embodiment is applied to various cameras such as a video camera in a manner similar to the first embodiment.

In the image pickup apparatus constructed as described above, the holder 8a and the holder holding member 9d which are engaged with each other in a part of the contact face hold the package 7 for enclosing the image pickup device 4 by sandwiching the package 7 from the upper and lower sides . Further, the image pickup apparatus has a structure such that the female screw portion 13 in the holder 8a and the male screw portion 6 in the lens barrel 5 for holding the optical parts (corresponding to the image forming lens 1, aperture 2, and infrared ray cut filter 3) are screwed to each other to thereby fix the holder 8a and the lens barrel 5.

As described above, the holder 8a and the holder holding member 9d sandwich the package 7 from the upper and lower sides and, simultaneously, in the image pickup apparatus, further, at least one of the holder 8a and the holder holding member 9d is provided with the structure by which they are pressed against each other, thereby firmly integrating the holder 8a and the holder holding member 9d. Specifically, in the embodiment, the inclined face 15 provided for the first engagement portion 11a is retained by the second engagement portion 12d provided for the holder holding member 9d, thereby achieving the integration.

The second engagement portion 12d in the holder holding member 9d has the engagement nail structure and the holder 8a and the holder holding member 9d are manufactured so that their dimensions in the Z axis (vertical) direction have minus tolerances in an engaged state, thereby sandwiching the package 7 by the holder 8a and the holder holding member 9d. Consequently, a force acts so that the second engagement portion 12d is opened outward along the inclined face 15, and by a force repelling it, the integration of the holder 8a and the holder holding member 9d becomes firm.

Since the fifth embodiment employs the structure of sandwiching the package 7 from the upper and lower sides by the holder 8a and the holder holding member 9d, an effect similar to that of the foregoing first embodiment is obtained. Further, since the inclined face 15 is provided for the first engagement portion 11a in the holder 8a, when the holder 8a and the holder holding member 9d are engaged with each other, the force acts so that the second engagement portion 12d is opened outward along the inclined face 15. By a force repelling it, the holder 8a and the holder holding member 9d are pressed against each other, so that the package 7 can be firmly sandwiched. That is, in the fifth embodiment, the strength in integration can be largely improved.

Fig. 6 is a diagram showing the configuration of a sixth embodiment of the image pickup apparatus. In the sixth embodiment, the same reference numerals are given to components similar to those of the foregoing first to fifth embodiments and their description will not be repeated. Although Fig. 6 has the configuration as an application of Fig. 1 for convenience of description, for example, in the cases of using the configurations of Figs. 2 to 5 as well, similar effects can be obtained.

In Fig. 6, reference numeral 17 denotes a projection provided for the package 7. In the embodiment, by inserting the projection 17 to a predetermined position in the holder holding member 9, the position in the x and y directions (plane direction) of the holder holding member 9 in the case of holding the package 7 is accurately specified.

Because of such a configuration, in the sixth embodiment, the effects in the first to fifth embodiments can be obtained and, further, the package 7 can be stably held without a deviation between the package 7 and the holder holding member 9. Thus, the integrated state can be more firmly held.

Fig. 7 is a diagram showing the configuration of a seventh embodiment of the image pickup apparatus. In the seventh embodiment, the same reference numerals are given to components similar to those of the foregoing first to sixth embodiments and their description will not be repeated. Although the structures of the first and second engagement portions in Fig. 7 are those of Fig. 1 for convenience of explanation, for example, in the cases of using the structures of Figs. 2 to 5 as well, similar effects can be obtained.

In Fig. 7, reference numeral 20 denotes an image forming lens with legs, and 21 indicates a holder for holding optical parts (image forming lens 20 with legs, aperture 2, and infrared ray cut filter 3). In the embodiment, by using the image forming lens 20 with legs, focal length adjustment becomes unnecessary.

Consequently, in the seventh embodiment, the effects in the first to fifth embodiments are obtained in the embodiment. By providing the image forming lens 20 with legs and the holder 21, it becomes unnecessary to provide the lens barrel 5 in the foregoing embodiment and further to adjust the focal length. Thus, the number of parts and the number of assembling steps can be further decreased.

As described above, according to the invention, there is no need to provide the package with a special structure for attaching the holder. At least one of the holder and the holder holding member has the structure by which they are pressed against each other, and it is unnecessary to provide the elastic member for absorbing the dimensional error in manufacture. Consequently, an effect such that the image pickup apparatus having excellent strength in integration between the optical system and the package, excellent light shielding performance, the reduced number of parts, and the reduced number of assembling steps can be obtained is produced.

Furthermore, since the elastic curved portion is provided in the contact portion between the holder holding member and the package, the holder and the holder holding member are pressed against each other to thereby firmly sandwich the package. An effect such that the intensity in integration can be largely improved by the above arrangement is produced.

Furthermore, since the inclined face is provided for the first engagement portion in the holder and, further, the second engagement portion in the holder holding member has the structure of the engagement hold, when the holder and the holder holding member are engaged with each other, a force acts so that the second engagement portion is opened outward along the inclined face. By the force repelling it, the holder and the holder holding member are pressed against each other to thereby firmly sandwich the package. Thus, an effect such that the strength in integration can be largely improved is produced.

Furthermore, the elastic curved portion is provided for the contact portion with the package of the holder holding member and, in addition, the second engagement portion of the engagement nail structure is provided. Consequently, when the first and second engagement portions are engaged with each other, the holder and the holder holding member are pressed against each other to thereby firmly sandwich the package. It produces an effect such that the intensity of integration can be more largely improved. The holder holding member having the second engagement portion of the structure of the engagement nail can be molded by using a resin such as plastic, so that an effect such that the manufacture is facilitated is produced.

Furthermore, since the second engagement portion in the holder holding member has the inclined face, when the holder and the holder holding member are engaged with each other, a force acts so that the second engagement portion is opened outward along the inclined face and, by the force repelling it, the holder and the holder holding member are pressed against each other to thereby firmly sandwich the package. It produces an effect such that the intensity of integration can be more largely improved.

Furthermore, since the first engagement portion in the holder has the inclined face and, further, the second engagement portion in the holder holding member has the structure of the engagement nail, when the holder and the holder holding member are engaged with each other, a force acts so that the second engagement portion is opened outward along the inclined face. By the force repelling it, the holder and the holder holding member are pressed against each other to thereby firmly sandwich the package. It produces an effect such that the intensity in integration can be more largely improved.

Furthermore, without a deviation between the package and the holder holding member, the package can be stably held. It produces an effect such that the integrated state can be more firmly held.

Furthermore, by fixing the distance between the image forming lens and the image pickup device, the adjustment of the focal length becomes unnecessary. It produces an effect such that the number of parts and the number of assembling steps can be further decreased.

Furthermore, according to the invention, an image pickup apparatus in which it is unnecessary to provide the package with a special structure for attaching the holder, at least one of the holder and the holder holding member has the structure by which they are pressed against each other, and it is unnecessary to provide an elastic member for absorbing a dimensional error in manufacture is used. It consequently produces an effect such that a camera having no condition which limits the shape of the package but having excellent intensity in integration between the optical system and the package, excellent light shielding performance, the reduced number of parts, and the reduced number of assembling steps can be obtained.

### INDUSTRIAL APPLICABILITY

The image pickup apparatus and the camera according to the invention have good integration between the optical system and the package and excellent light shielding performance, and are suitable for realizing reduction in the number of parts and the number of assembling steps.

## Claims

1. An image pickup apparatus comprising:
a holder for holding optical parts; and
a holder holding member, a part of which is engaged with said holder, for holding a package enclosing an image pickup device in an engaged state,
wherein a first engagement portion provided for said holder and a second engagement portion provided for said holder holding member are engaged with each other to sandwich said package from the upper and lower sides, and
at least one of said holder and said holder holding member has a structure by which said holder and said holder holding member are pressed against each other, thereby integrating said package and said optical parts.

2. The image pickup apparatus according to claim 1, wherein
an elastic curved portion is provided for said holder holding member,
the second engagement portion in said holder holding member has the structure of an engagement hole, and
when said first and second engagement portions are engaged with each other and said curved portion is pressed down, and said holder and said holder holding member are pressed against each other.

3. The image pickup apparatus according to claim 1, wherein
an inclined face is provided for a first engagement portion in said holder,
the second engagement portion in said holder holding member has the structure of an engagement hole,
the inclined face of said first engagement portion and said second engagement portion are engaged with each other, and
said holder and said holder holding member are pressed against each other by a repulsive force applied along said inclined face to said holder holding member.

4. The image pickup apparatus according to claim 1, wherein
an elastic curved portion is provided for said holder holding member,
the second engagement portion in said holder holding member has the structure of an engagement nail, and
when said first and second engagement portions are engaged with each other and said curved portion is pressed down, and said holder and said holder holding member are pressed against each other.

5. The image pickup apparatus according to claim 1, wherein
an inclined face is provided for a second engagement portion in said holder holding member,
the second engagement portion in said holder holding member has the structure of an engagement nail, and
when said first engagement portion and the inclined face of said second engagement portion are engaged with each other, and said holder and said holder holding member are pressed against each other by a repulsive force applied along said inclined face to said holder holding member.

6. The image pickup apparatus according to claim 1, wherein
an inclined face is provided for the first engagement portion in said holder,
the second engagement portion in said holder holding member has the structure of an engagement nail, and
when the inclined face of said first engagement portion and said second engagement portion are engaged with each other, and said holder and said holder holding member are pressed against each other by a repulsive force applied along said inclined face to said holder holding member.

7. The image pickup apparatus according to claim 1, wherein
said package is provided with a projection for defining a holding position between the rear face of said package and said holder holding member.

8. The image pickup apparatus according to claim 1, wherein
a distance between the image forming lens as one of said optical parts and said image pickup device is fixed, thereby making adjustment of a focal length unnecessary.

9. A camera comprising:
an image pickup apparatus in which
a first engagement portion provided for a holder for holding optical parts and a second engagement portion provided for a holder holding member are engaged with each other to sandwich a package enclosing an image pickup device from the upper and lower sides, and
at least one of said holder and said holder holding member has a structure by which the said holder and said holder holding member are pressed against each other, thereby integrating said package and said optical parts.
